# EUROPEAN PATENT APPLICATION

(11) **EP 4 748 627 A1**
(43) Date of publication of application: **27.05.2026**
(21) Application number: 24844486.1
(22) Date of filing: 21.06.2024
(51) Int. Cl.: B60L 53/12, B60L 53/302, H02J 50/12

(54) **VEHICLE WIRELESS CHARGING TRANSMITTING APPARATUS AND SYSTEM**

(30) Priority: 21.07.2023 CN 202310905294
(71) Applicant: Ningbo Shintai Machines Co., Ltd., Ningbo City Zhejiang province (CN)
(72) Inventor: LI, Guozheng, Ningbo, Zhejiang 315800 (CN); REN, Ruyu, Ningbo, Zhejiang 315800 (CN); ZHOU, Jilong, Ningbo, Zhejiang 315800 (CN); XU, Xihong, Ningbo, Zhejiang 315800 (CN)
(74) Representative: Murgitroyd & Company
(86) International application number: PCT/CN2024/100528
(87) International publication number: WO 2025/020792

(57) **Abstract**

The invention provides a vehicle wireless charging transmitting apparatus and system. The vehicle wireless charging transmitting apparatus includes a cover body, a mounting base, a power supply device and a transmitting device. The cover body is configured for covering the mounting base and the two form a charging box, an accommodating space is formed between the cover body and the mounting base, and the power supply device and the transmitting device are provided in the accommodating space. The power supply device and the transmitting device are integrally arranged in the accommodating space of the charging box. Thus, the power supply device, the transmitting device and a circuit between the two are enclosed in the charging box, effectively avoiding potential safety hazards caused by exposure of an excitation wire between the power supply device and the transmitting device in the prior art, ensuring the normal operation of the wireless charging apparatus.

## Description

### Technical Field

The present invention relates to the technical field of new energy vehicle, and in particular, to a vehicle wireless charging transmitting apparatus and system.

### Background Art

The existing vehicle wireless charging transmitting apparatus mainly includes a power supply device and a transmitting device. The power supply device is electrically connected to the transmitting device via an excitation wire. The power supply device is connected to mains electricity for converting mains alternating current into direct current and then into high-frequency alternating current and transmitting same to the transmitting device via the excitation wire, and the transmitting device is wirelessly connected to a receiver provided in the vehicle so as to couple a high-frequency magnetic field generated by the transmitting device with a magnetic field of a coil of the receiver to achieve electric energy transmission so as to wirelessly charge a battery pack of the vehicle.

However, since the power supply device and the transmitting device are usually provided separately, the excitation wire between the power supply device and the transmitting device is exposed, so that the exposed excitation wire not only has a safety risk due to being easily scratched or crushed by foreign objects, but also affects the normal operation of the peripheral devices due to the magnetic field generated by the exposed excitation wire, thus affecting the normal operation of the wireless charging apparatus.

### Summary of the Invention

The problem to be solved by the present invention is that an excitation wire between a power supply device and a transmitting device in a vehicle wireless charging transmitting apparatus in the prior art is exposed, so that a safety risk is easily generated and the normal operation of peripheral devices is affected, thereby affecting the normal operation of the whole vehicle wireless charging transmitting apparatus.

In order to solve the above-mentioned problems, in a first aspect, the present invention provides a vehicle wireless charging transmitting apparatus, including a cover body, a mounting base, a power supply device and a transmitting device, wherein the cover body is configured for covering the mounting base and the two form a charging box; an accommodating space is formed between the cover body and the mounting base; and the power supply device and the transmitting device are provided in the accommodating space.

Optionally, the transmitting device includes a coil assembly and a magnetic material layer; and the coil assembly, the magnetic material layer and at least a part of the power supply device are laminated in the direction of the central axis of the charging box.

Optionally, a mounting groove is provided inside the mounting base; the power supply device and the transmitting device are respectively provided in the mounting groove; and the depth of the mounting groove is greater than the thickness of the power supply device and/or the transmitting device.

Optionally, the charging box further includes a first support structure; the first support structure includes a plurality of support ribs, and each of the support ribs is provided in the cover body and/or the mounting base; a plurality of mounting positions are defined between the support ribs and a circumferential side wall of the cover body and/or the mounting base; and the power supply device and the transmitting device are respectively provided in each of the mounting positions.

Optionally, the vehicle wireless charging transmitting apparatus further includes a heat dissipation assembly provided in the charging box, wherein the heat dissipation assembly includes a cooling plate; a cooling medium flow passage is provided inside the cooling plate; and at least part of the power supply device is provided on the cooling plate.

Optionally, the power supply device includes a power PCB plate and a control PCB plate; the coil assembly, the magnetic material layer and the control PCB plate are laminated in the direction of the central axis of the charging box; the power PCB plate and the control PCB plate are arranged in a horizontal direction inside the charging box; and at least one of the power PCB plate, the control PCB plate and the transmitting device is provided on the cooling plate.

Optionally, the vehicle wireless charging transmitting apparatus further includes a first shield plate provided between the magnetic material layer and the control PCB plate.

Optionally, the cooling medium flow passage is provided around at least one of the power PCBplate (31), the control PCB plate, and the transmitting device; and the cooling plate is provided with a liquid inlet and a liquid outlet communicating with the cooling medium flow passage; the liquid inlet and the liquid outlet are configured for communicating with an external cooling apparatus.

Optionally, the power supply device includes a power PCB plate and a control PCB plate; the power PCB plate and the control PCB plate are respectively provided on a side of the magnetic material layer away from the coil assembly; and the magnetic material layer and the power supply device are respectively provided on two opposite sides of the cooling plate.

Optionally, the cooling medium flow passage is provided around the power PCB plate, the control PCB plate and the transmitting device.

Optionally, the cooling plate is made of a shield material.

Optionally, the vehicle wireless charging transmitting apparatus further includes an insulating plate provided between the magnetic material layer and the cooling plate.

Optionally, the cooling plate includes a plate body on which the cooling medium flow passage is provided, and a sealing cover which is sealingly connected to the plate body.

Optionally, the vehicle wireless charging transmitting apparatus further includes a heat dissipation assembly including a heat sink and a fan, wherein the heat sink is provided in the charging box; at least part of the power supply device is provided on the heat sink; a plurality of air guide channels are provided on a surface of the heat sink; and the fan is provided on a side wall of the charging box and provided opposite to the air guide channels of the heat sink.

Optionally, the power supply device includes a power PCB plate and a control PCB plate; the coil assembly, the magnetic material layer, and the control PCB plate are laminated in the direction of the central axis of the charging box; the power PCB plate and the control PCB plate are arranged in a horizontal direction within the charging box; and the power PCB plate is provided on the heat sink.

Optionally, the vehicle wireless charging transmitting apparatus further includes a second shield plate provided between the magnetic material layer and the power supply device.

Optionally, a first positioning structure is provided on the second shield plate; and the magnetic material layer is provided with a second positioning structure corresponding to the first positioning structure.

Optionally, the power supply device includes a power PCB plate and a control PCB plate; the power PCB plate and the control PCB plate are respectively provided on a side of the magnetic material layer away from the coil assembly; and at least part of the power supply device is provided at the heat sink.

Optionally, a third positioning structure is provided in the mounting groove; a fourth positioning structure is provided on the heat sink; and the fourth positioning structure is adapted to be connected to the third positioning structure when the heat sink is provided in the mounting groove.

Optionally, a side wall of the mounting base is provided with an avoidance opening; and the fan is provided in the avoidance opening.

Optionally, the heat dissipation assembly further includes a protection plate which is provided at the avoidance groove to shield the fan.

Optionally, the vehicle wireless charging transmitting apparatus further includes a living body detection device and a foreign object detection device; and the living body detection device and the foreign object detection device are provided in the charging box, respectively.

Compared with the prior art, the present invention forms a charging box by a cover body being covered on a mounting base. After the cover body is covered on the mounting base, an accommodating space is formed between the cover body and the mounting base. A power supply device and a transmitting device are integrally arranged in the accommodating space of the charging box. The power supply device and the transmitting device are electrically connected via a line, such as an excitation wire, so that the power supply device and the transmitting device and the excitation wire therebetween are enclosed in the charging box, so as to avoid the excitation wire from being exposed. Therefore, not only the safety hazard caused by the exposed excitation wire between the power supply device and the transmitting device in the prior art can be effectively avoided, but also the magnetic field generated by the exposed excitation wire can be avoided so as not to affect the normal operation of the peripheral devices outside the vehicle wireless charging transmitting apparatus. Thus, the normal operation of the whole vehicle wireless charging transmitting apparatus can be ensured.

The present invention also provides a vehicle wireless charging system including the vehicle wireless charging transmitting apparatus as described above, and further including a receiving device, wherein the transmitting device of the vehicle wireless charging transmitting apparatus is wirelessly connected to the receiving device.

Accordingly, since the vehicle wireless charging system includes the above-described vehicle wireless charging transmitting apparatus, the vehicle wireless charging system has at least all the technical effects of the vehicle wireless charging transmitting apparatus, and will not be described in detail herein.

### Brief Description of the Drawings

Fig. 1 is a schematic diagram showing a simplified structure of a vehicle wireless charging transmitting apparatus according to an embodiment of the present invention;
Fig. 2 is an exploded schematic structural view of a first vehicle wireless charging transmitting apparatus according to an embodiment of the present invention;
Fig. 3 is a partial schematic view of a first vehicle wireless charging transmitting apparatus according to an embodiment of the present invention;
Fig. 4 is a structurally schematic view of a first water tank mounting plate according to an embodiment of the present invention;
Fig. 5 is a structurally schematic view of a first cooling plate according to an embodiment of the present invention;
Fig. 6 is a schematic cross-sectional view of a first vehicle wireless charging transmitting apparatus according to an embodiment of the present invention;
Fig. 7 is an exploded schematic structural diagram of a second vehicle wireless charging transmitting apparatus according to an embodiment of the present invention;
Fig. 8 is an exploded perspective view of a second mounting base according to an embodiment of the present invention;
Fig. 9 is an exploded schematic structural view of a second cooling plate according to an embodiment of the present invention;
Fig. 10 is a schematic cross-sectional view of a second vehicle wireless charging transmitting apparatus according to an embodiment of the present invention;
Fig. 11 is an exploded schematic structural view of a third vehicle wireless charging transmitting apparatus according to an embodiment of the present invention;
Fig. 12 is a partial schematic view I of a third vehicle wireless charging transmitting apparatus according to an embodiment of the present invention;
Fig. 13 is a partial schematic view II of a third vehicle wireless charging transmitting apparatus according to an embodiment of the present invention;
Fig. 14 is a schematic cross-sectional view of the third vehicle wireless charging transmitting apparatus according to an embodiment of the present invention;
Fig. 15 is an exploded schematic structural view of a fourth vehicle wireless charging transmitting apparatus according to the embodiment of the present invention;
Fig. 16 is a partial schematic view I of a fourth vehicle wireless charging transmitting apparatus according to an embodiment of the present invention;
Fig. 17 is a partial schematic view II of the fourth vehicle wireless charging transmitting apparatus according to an embodiment of the present invention;
Fig. 18 is a schematic cross-sectional view of the fourth vehicle wireless charging transmitting apparatus according to an embodiment of the present invention; and
Fig. 19 is a schematic block diagram of a vehicle wireless charging system according to an embodiment of the present invention.

### Description of Reference Numerals:

1-cover body; 2-mounting base; 21-mounting groove; 22-first support structure; 23-third positioning structure; 24-countersink; 3-power supply device; 31-power PCB plate; 311-PFC circuit; 312-DC voltage regulating circuit; 313-inverter circuit; 32-control PCB plate; 33-fixing support; 4-transmitting device; 41-coil assembly; 411-tray; 412-primary side coil; 42-magnetic material layer; 421-second positioning structure; 43-resonance network; 5-heat dissipation assembly; 51-cooling plate; 511-cooling medium flow passage; 512-liquid inlet; 513-liquid outlet; 52-water tank mounting plate; 53-heat sink; 531-second support structure; 54-fan; 55-protection plate; 56-waterproof sealing structure; 6-first shield plate; 7-insulating plate; 9-second shield plate; 91-first positioning structure; 10-living body detection device; 11-foreign object detection device; 12-connector; 13-receiving device.

### Detailed Description of the Invention

To make the above objects, features and advantages of the present invention more apparent, a detailed description of specific embodiments of the present invention will be made with reference to the accompanying drawings.

It is noted that the terms "first", "second", and the like in the description and in the claims of the present invention, as well as in the above-described figures, are used for distinguishing between similar objects and not necessarily for describing a particular sequential or chronological order. It should be understood that the data so used may be interchanged, where appropriate, so that the examples of the present invention described herein can be implemented in an order other than those illustrated or described herein.

In the description of the present invention, it should be noted that, unless otherwise expressly specified or limited, the terms "provided", "mounted", "connected", and "linked" are to be interpreted broadly. For example, a connection may be fixed, detachable, or integral; it may be mechanical; it may be direct or indirect through an intermediate medium; or it may refer to the internal communication between two components. For those of ordinary skill in the art, the specific meanings of the above terms in the present invention can be understood according to specific circumstances.

Reference in the description to "embodiments", "an embodiment", "an implementation", and so forth, means that a particular feature, structure, material, or characteristic described in connection with the embodiment or implementation is included in at least one embodiment or implementation of the present invention. In the present specification, schematic statement of the above terms do not necessarily refer to the same embodiment or implementation. Furthermore, the particular features, structures, materials, or characteristics described may be combined in any suitable manner in any one or more embodiments or implementations.

In order to solve the above-mentioned technical problem, according to a first aspect of the present invention, there is provided a vehicle wireless charging transmitting apparatus, including a cover body 1, a mounting base 2, a power supply device 3 and a transmitting device 4. The cover body 1 is configured for covering the mounting base 2 and the two form a charging box. An accommodating space is formed between the cover body 1 and the mounting base 2. The power supply device 3 and the transmitting device 4 are provided in the accommodating space.

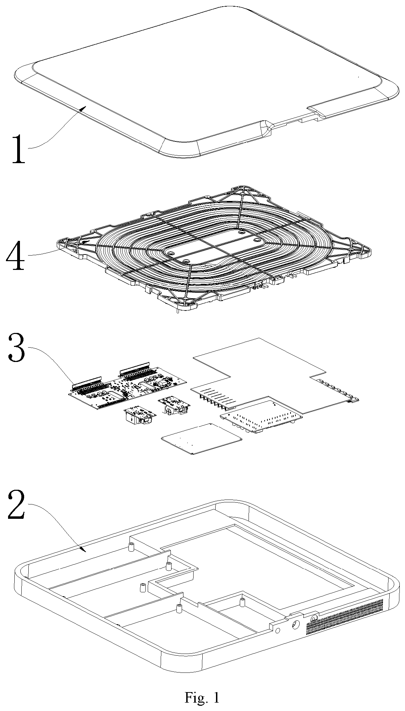

In the present embodiment, as shown in conjunction with Fig. 1, a cover body 1 is provided above a mounting base 2. The cover body 1 is configured for detachably covering the mounting base 2. When the cover body 1 is covered on the mounting base 2, an accommodating space is formed therebetween, and the accommodating space is configured for mounting electrical equipment, such as a power supply device 3 and a transmitting device 4, of a vehicle wireless charging transmitting apparatus. Since the power supply device 3 and the transmitting device 4 are integrally mounted in the accommodating space, an excitation wire between the power supply device 3 and the transmitting device 4 is also located inside a charging box, so as to prevent the excitation wire from being exposed and avoid potential safety hazards.

In this embodiment, a charging box is formed by a cover body 1 being covered on a mounting base 2. After the cover body 1 is covered on the mounting base 2, an accommodating space is formed between the cover body 1 and the mounting base 2. A power supply device 3 and a transmitting device 4 are integrally arranged in the accommodating space of the charging box. The power supply device 3 and the transmitting device 4 are electrically connected via a line, such as an excitation wire, so that the power supply device 3, the transmitting device 4 and the excitation wire therebetween are enclosed in the charging box, so as to avoid the excitation wire from being exposed. Thus, not only the safety hazard caused by the exposed excitation wire between the power supply device 3 and the transmitting device 4 in the prior art can be effectively avoided, but also the magnetic field generated by the exposed excitation wire can be avoided so as not to affect the normal operation of the peripheral devices outside the vehicle wireless charging transmitting apparatus. Thus, the normal operation of the whole vehicle wireless charging transmitting apparatus can be ensured.

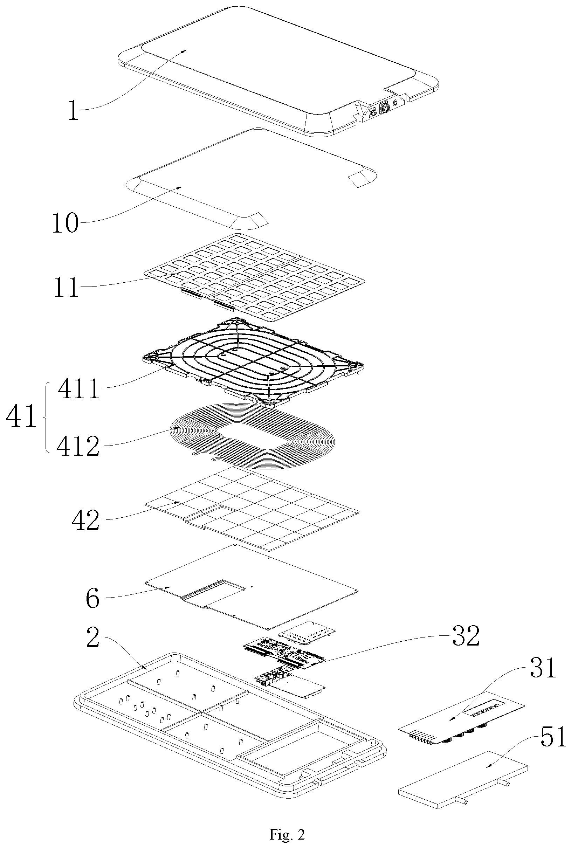

Optionally, as shown in conjunction with Fig. 2, Fig. 7, Fig. 11, and Fig. 15, the transmitting device 4 includes a coil assembly 41 and a magnetic material layer 42r; and the coil assembly 41, the magnetic material layer 42 and at least a part of the power supply device 3 are laminated in the direction of the central axis of the charging box.

In the present embodiment, by laminating the coil assembly 41, the magnetic material layer 42, and at least a part of the power supply device 3 along the central axis of the charging box, it is not only convenient for quick assembly of the coil assembly 41, the magnetic material layer 42, and at least a part of the power supply device 3 in the charging box, but also can effectively reduce the size of the charging box in the horizontal direction, effectively reducing the production and assembly costs of the vehicle wireless charging transmitting apparatus. Here, the center axis of the charging box refers to an axis perpendicular to the cover body 1 and the mounting base 2 in the charging box in a vertical plane. The power supply device 3 is electrically connected to a coil assembly 41 for supplying alternating current electric power to the coil assembly 41. The coil assembly 41 is configured for performing electromagnetic energy conversion on the basis of the alternating current electric power of the power supply device 3 to transmit electromagnetic energy to the receiving device 13 located on the vehicle to realize a wireless charging operation for the electric vehicle. The magnetic material layer 42 may take the form of ferrite, which has a plate-like structure and is provided adjacent to the coil assembly 41 for magnetic conduction and coupling action to the coil assembly 41.

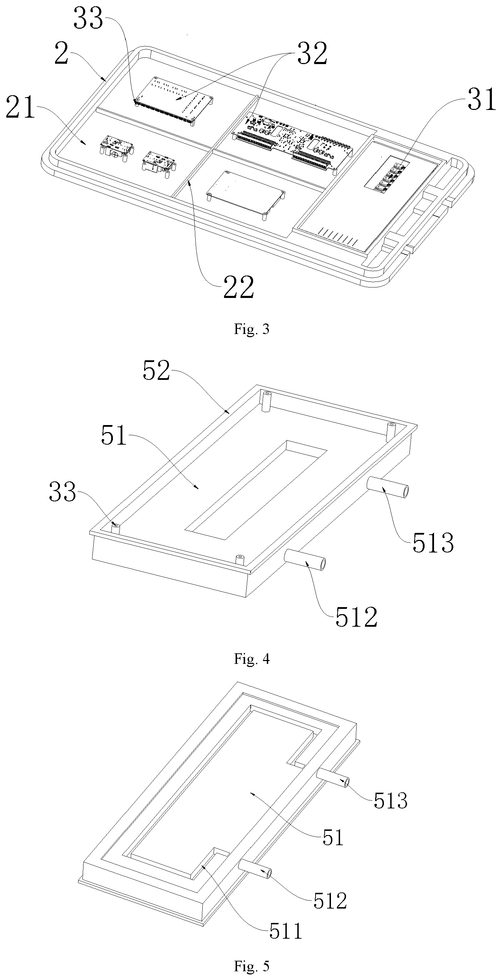

Optionally, as shown in connection with Figs. 3, 8, 12 and 16, a mounting groove 21 is provided inside the mounting base 2. The power supply device 3 and the transmitting device 4 are respectively provided in the mounting groove 21. The depth of the mounting groove 21 isg greater than the thickness of the power supply device 3 and/or the transmitting device 4.

In the present embodiment, the interior of the mounting groove 21 is configured for mounting the power supply device 3 and the transmitting device 4, and the cover body 1 is covered in the mounting groove 21 of the mounting base 2, so that the power supply device 3 and the transmitting device 4 can be integrated in the charging box. The power supply device 3 and the transmitting device 4 are connected via a line, such as an excitation wire, so as to effectively seal the excitation wire between the power supply device 3 and the transmitting device 4 in the charging box, thereby achieving the safety protection of the excitation wire. In addition, by setting the depth of the mounting groove 21 to be greater than the thickness of the power supply device 3, or greater than the thickness of the transmitting device 4, or greater than the thicknesses of the power supply device 3 and the transmitting device 4, when an external object, such as a vehicle or a person, passes through the charging box, the cover body 1 of the charging box is deformed and bent downwards by the downward force applied thereto. Since the depth of the height of the mounting groove 21 is greater than the thickness of the power supply device 3 and/or the transmitting device 4, the outer periphery of the mounting groove 21 abuts against the deformed cover body 1 so as to prevent the cover body 1 from being further deformed downwards to crush the power supply device 3 and the transmitting device 4 in the mounting groove 21, thereby serving as an anti-crushing function for the power supply device 3 and the transmitting device 4.

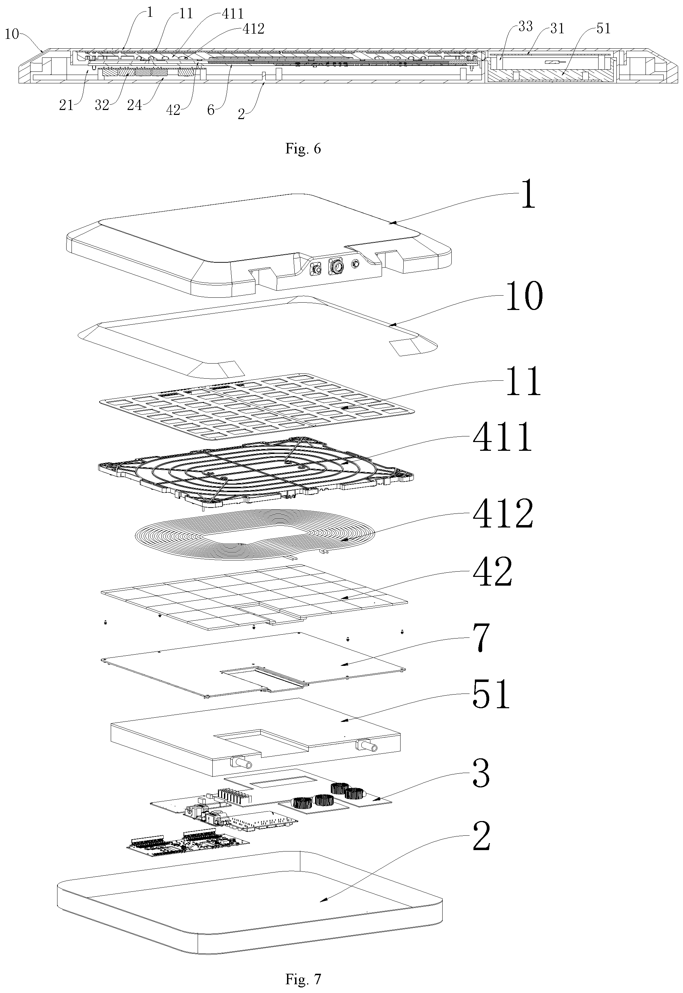

In addition, in conjunction with Fig. 6, the interior of the mounting base 2 is further provided with a countersink 24 located in the mounting groove 21. The height of the bottom wall of the countersink 24 is lower than the bottom wall of the mounting groove 21, and the top end of the countersink 24 corresponds to the height of the bottom wall of the mounting groove 21. At least part of the power supply device 3 is mounted in the countersink 24, and the bottom of the power supply device 3 is located in the countersink 24. A gap is reserved between the bottom of the power supply device 3 and the bottom wall of the countersink 24, so that even when the cover body 1 is subjected to a large downward force to generate bending deformation and apply a force to the power supply device 3, at the moment, since the bottom of the power supply device 3 is located in the countersink 24 and the gap is reserved between the bottom of the power supply device 3 and the bottom wall of the countersink 24, the power supply device 3 will be bent downwards when subjected to the pressing force transmitted from the cover body 1. In other words, the space serves as a deformation allowance space of the power supply device 3, the cover body 1 can be effectively prevented from directly crushing the power supply device 3 when subjected to a large force, thereby further achieving a safety protection function for the power supply device 3.

Herein, the mounting groove 21 can be a space region surrounded by a circumferential side wall and a bottom wall of the mounting base 2. If the mounting base 2 is a quadrangular prism structure with an open top end, the mounting base 2 has four circumferential side walls and one bottom wall. If the mounting base 2 is a hexagonal prism structure with an open top end, the mounting base 2 has six circumferential side walls and a bottom wall. For this reason, the space region enclosed between the circumferential side wall and the bottom wall of the mounting base 2 is configured for mounting the power supply device 3 and the transmitting device 4. Thus, the depth of the mounting groove 21 at the moment refers to the height of the circumferential side wall of the mounting groove 21. Therefore, the circumferential side wall of the mounting groove 21 can play a role of preventing the cover body 1 from being crushed when pressed by an external object.

Optionally, the charging box further includes a first support structure 22. The first support structure 22 includes a plurality of support ribs, and each of the support ribs is provided in the cover body 1 and/or the mounting base 2; a plurality of mounting positions are defined between the support ribs and a circumferential side wall of the cover body 1 and/or the mounting base 2. The power supply device 3 and the transmitting device 4 are respectively provided in each of the mounting positions.

In the present embodiment, for example, a plurality of support ribs are provided on the inner bottom wall of the mounting base 2. As shown in Fig. 3, Fig. 8, Fig. 12, and Fig. 16, the first support structure 22 is provided in the mounting groove 21 of the mounting base 2. The first support structure 22 includes a plurality of support ribs. Each of the support ribs is arranged alternately, and the plurality of support ribs respectively enclose a plurality of mounting positions with the circumferential side wall of the mounting groove 21 of the mounting base 2, which is equivalent to dividing the mounting groove 21 into a plurality of mounting positions. The power supply device 3 and the transmitting device 4 are respectively provided in each mounting position. When each electronic component in the power supply device 3 and the transmitting device 4 is respectively provided in each mounting position, each mounting position at the moment not only provides a specific mounting position for the power supply device 3 and the transmitting device 4, so that the power supply device 3 and the transmitting device 4 do not generate faults, such as dislocation and movement, under the impact of an external force, so as to realize the positioning function of the power supply device 3 and the transmitting device 4, but also each support rib supports the cover body 1 from a region inside the circumferential side wall of the mounting base 2. When the middle region of the cover body 1 bends and deforms downwards under an external pressing force, at the moment, each support rib in the mounting base 2 supports the cover body 1, so as to prevent the cover body 1 from being deformed excessively downwards and crushing the power supply device 3 and the transmitting device 4, thereby further achieving the function of anti-crush protection of the power supply device 3 and the transmitting device 4.

Optionally, only the cover body 1 is provided with a first support structure 22, for example, facing the surface of the mounting base 2. The first support structure 22 includes a plurality of support ribs, and the plurality of support ribs are arranged in a staggered manner. A plurality of mounting positions are enclosed between the support ribs and the circumferential side wall of the mounting base 2. The power supply device 3 and the transmitting device 4 are respectively arranged in each mounting position. In this case, the mounting position not only provides a mounting space for the power supply device 3 and the transmitting device 4, but also can play an anti-crush protective role for the power supply device 3 and the transmitting device 4.

Optionally, a first support structure 22 (not shown in the figure) is provided on both the mounting base 2 and the cover body 1, and the first support structure 22 includes a plurality of support ribs arranged in a staggered manner. Each mounting position is defined between the support ribs and the circumferential side wall of the cover body 1. In this case, the mounting position not only provides a mounting space for the power supply device 3 and the transmitting device 4, but also provides the first support structure 22 on both the mounting base 2 and the cover body 1, so as to further improve the anti-crush protection effect on the power supply device 3 and the transmitting device 4 by increasing the height of the support ribs of the first support structure 22.

Optionally, the vehicle wireless charging transmitting apparatus further includes a heat dissipation assembly 5 provided in the charging box. The heat dissipation assembly 5 includes a cooling plate 51. A cooling medium flow passage 511 is arranged in the interior of the cooling plate 51, and at least part of the power supply device 3 is provided on the cooling plate 51.

In this embodiment, by providing the cooling medium flow passage 511 in the cooling plate 51, and at least part of the power supply device 3 in the cooling plate 51, the power supply device 3 is cooled by the cooling medium flow passage 511 in the cooling plate 51, so that the operating temperature of the power supply device 3 is always within a relatively suitable temperature range, which can not only keep the normal operation of the power supply device 3, but also can correspondingly extend the service life of the power supply device 3.

The cooling medium inside the cooling medium flow passage 511 may be circulating cold water, circulating oil, or another cooling medium, and is not particularly limited here.

Optionally, the power supply device 3 includes a power PCB plate 31 and a control PCB plate 32. The coil assembly 41, the magnetic material layer 42, and the control PCB plate 32 are laminated in the direction of the central axis of the charging box. The power PCB plate 31 and the control PCB plate 32 are provided in a horizontal direction within the charging box. At least one of the power PCB plate 31, the control PCB plate 32, and the transmitting device 4 is provided on the cooling plate 51.

In this embodiment, as shown in Figs. 2 and 3, by laminating the coil assembly 41, the magnetic material layer 42, and the control PCB plate 32 in the direction of the central axis of the charging box, it is possible not only to effectively reduce the size of the charging box in the horizontal direction, but also to cool down at least one of the power PCB plate 31, the control PCB plate 32, and the transmitting device 4 in flow mode of the circulating medium by the cooling board 51, so as to ensure that the vehicle wireless charging transmitting apparatus can be operated for a long time to accordingly prolong its service life. Herein, the power PCB plate 31 and the control PCB plate 32 are arranged in a horizontal direction in the charging box, which means that the power PCB plate 31 is provided on one side, for example, a front side, a rear side, a left side or a right side, of the control PCB plate 32 in the horizontal direction, so that the length or the width of the mounting base 2 in the charging box can be effectively reduced, so as to reduce the volume of the charging box, thereby reducing the production cost of the wireless charging apparatus.

In addition, at least one of the power PCB plate 31, the control PCB plate 32 and the transmitting device 4 is provided on the cooling plate 51, which means that any one of the power PCB plate 31, the control PCB plate 32 and the transmitting device 4 is provided on the cooling plate 51, or any two of the power PCB plate 31, the control PCB plate 32 and the transmitting device 4 are provided on the cooling plate 51, or three of the power PCB plate 31, the control PCB plate 32 and the transmitting device 4 are respectively provided on the cooling plate 51.

The coil assembly 41 includes a primary side coil 412 and a tray 411. The primary side coil 412 is provided on the tray 411, and therefore the tray 411 is configured for winding the primary side coil 412.

Optionally, as shown in conjunction with Figs. 2 and 6, the vehicle wireless charging transmitting apparatus further includes a first shield plate 6 provided between the magnetic material layer 42 and the control PCB plate 32.

In the present embodiment, since the coil assembly 41, the magnetic material layer 42 and the control PCB plate 32 are laminated along the central axis of the charging box when the coil assembly 41 and the magnetic material layer 42 generate electromagnetic interference to the control PCB plate 32, thereby affecting the normal operation of the control PCB plate 32. Thus, by providing the first shield plate 6 between the magnetic material layer 42 and the control PCB plate 32, the electromagnetic interference of the coil assembly 41 and the magnetic material layer 42 to the control PCB plate 32 can be shielded by the first shield plate 6, thereby ensuring the normal operation of the control PCB plate 32.

The first shield plate 6 may be an aluminum plate, and may also be a plate made of other shield materials, which is not specifically limited herein.

Optionally, the cooling medium flow passage 511 is provided around at least one of the power PCB plate 31, the control PCB plate 32 and the transmitting device 4. The temperature reducing plate 51 is provided with a liquid inlet 512 and a liquid outlet 513 communicating with the cooling medium flow passage 511. The liquid inlet 512 and liquid outlet 513 are configured for communicating with an external cooling apparutus.

In this embodiment, in conjunction with what is shown in Fig. 5, by providing a liquid inlet 512 and a liquid outlet 513 on the side wall of the cooling plate 51 and communicating with the cooling medium flow passage 511, and the liquid inlet 512 and the liquid outlet 513 being configured for communicating with an external cooling apparatus, a low-temperature cooling medium, such as cold water, can be output by the external cooling apparatus and enters the cooling medium flow passage 511 via the liquid inlet 512 so as to absorb the heat generated by the operation of at least one of the power PCB plate 31, the control PCB plate 32 and the transmitting device 4 provided on the cooling plate 51. At this moment, the cooling medium, such as cold water, of the cooling medium flow passage 511 changes into warm water, and then is discharged from the liquid outlet 513 into the external cooling apparatus, so as to effectively use the cooling medium to flow in the cooling medium flow passage 511 to effectively cool down at least one of the power PCB plate 31, the control PCB plate 32 and the transmitting device 4 in real time. Further, at least one of the power PCB plate 31, the control PCB plate 32, and the transmitting device 4 is provided around at least one of the power PCB plate 31, the control PCB plate 32, and the transmitting device 4 by the cooling medium flow passage 511, so that the heat generated by the operation of at least one of the power PCB plate 31, the control PCB plate 32, and the transmitting device 4 can be more absorbed from the circumferential direction by the cooling medium flow passage 511, further improving the heat radiation and temperature reduction effect of at least one of the power PCB plate 31, the power PCB plate 32, and the transmitting device 4.

Here, with reference to Figs. 3 and 6, the cooling medium flow passage 511 is provided around the power PCB plate 31 as an example. In other words, the cooling medium flow passage 511 is an annular flow passage, and the power PCB plate 31 is provided in the annular flow passage, so that the cooling effect on the power PCB plate 31 is effectively improved. Of course, the cooling medium flow passage 511 is provided around at least one of the power PCB plate 31, the control PCB plate 32, and the transmitting device 4. In the manner of referring to the above-described embodiment, in other words, the circumference of the cooling medium flow passage 511 is increased, so that it is possible to achieve cyclic cooling of a plurality of electric appliances such as the power PCB plate 31, the control PCB plate 32, and the transmitting device 4, which will not be described in detail herein.

In addition, the external cooling apparatus is configured for cooling the warm water coming out from the liquid outlet 513 of the cooling plate 51 into cold water, and then outputting the cold water into the cooling medium flow passage 511 via the liquid inlet 512 of the cooling plate 51. The external cooling apparatus is configured for providing a cooling medium which can be circulated, and a water cooling apparatus in the prior art can be used, which will not be repeated here. As long as the external cooling apparatus capable of supplying the circulating cooling medium can be provided, it is applicable to this technical solution and will not be described in detail herein.

In the present embodiment, as shown in Figs. 3, 4 and 6, the vehicle wireless charging transmitting apparatus further includes a water tank mounting plate 52 and a fixing support 33. The water tank mounting plate 52 is provided in the mounting groove 21 of the mounting base 2, and the cooling plate 51 is provided in the water tank mounting plate 52, so that the water tank mounting plate 52 is configured for stably fixing the cooling plate 51 in the mounting groove 21 of the mounting base 2. A plurality of fixing supports 33 are provided at intervals in the mounting groove 21. The power PCB plate 31 can be mounted on the fixing support 33 by means of screws or snap-in posts. The bottom of the power PCB plate 31 can be directly in contact with the cooling plate 51, or a space can be reserved between same and the cooling plate 51. Therefore, the cooling of the power PCB plate 31 can be performed by means of the flow of the circulating medium via the cooling plate 51.

Optionally, as shown in conjunction with Fig. 7, the power supply device 3 includes a power PCB plate 31 and a control PCB plate 32. The power PCB plate 31 and the control PCB plate 32 are respectively provided on a side of the magnetic material layer 42 away from the coil assembly 41. The magnetic material layer 42 and the power supply device 3 are respectively provided on two opposite sides of the cooling plate 51.

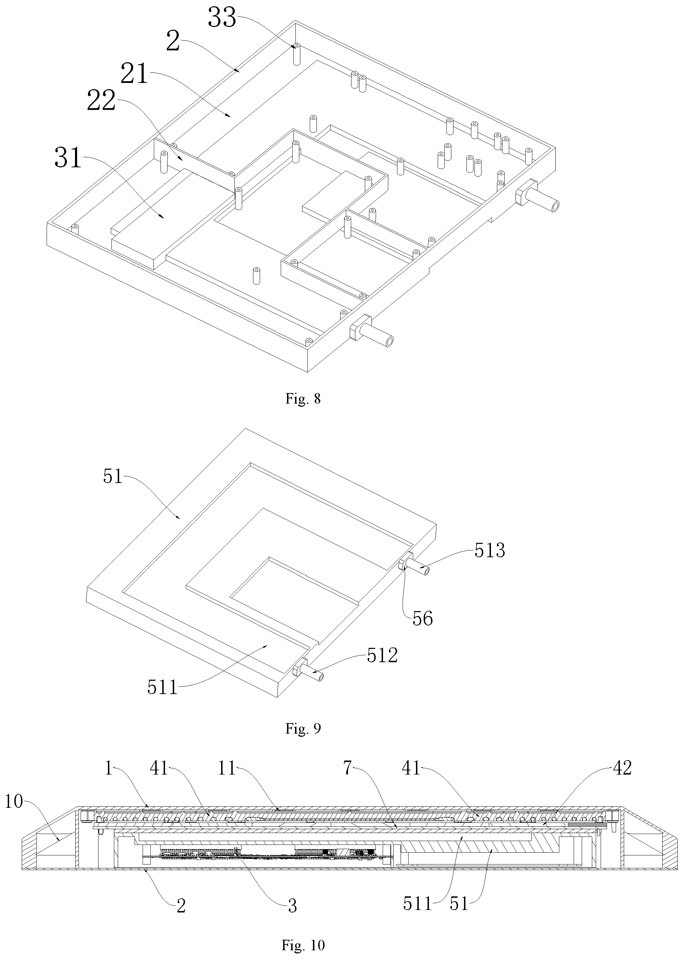

In the present embodiment, the power PCB plate 31 and the control PCB plate 32 being respectively provided on a side of the magnetic material layer 42 away from the coil assembly 41 means that, with respect to the position of the magnetic material layer 42, if the coil assembly 41 is located above the magnetic material layer 42, the power PCB plate 31 and the control PCB plate 32 are both located below the magnetic material layer 42. In other words, the coil assembly 41, the magnetic material layer 42, and the power PCB plate 31 and the control PCB plate 32 in the power supply device 3 are laminated, so that it is possible to effectively reduce the length and the width in the horizontal direction in the vehicle wireless charging transmitting apparatus, to reduce the volume of the vehicle wireless charging transmitting apparatus, and thus to reduce the cost. With reference to Figs. 7 and 8, the magnetic material layer 42 and the power supply device 3 are respectively provided on two opposite sides of the cooling plate 51. In other words, the cooling plate 51 is provided between the transmitting device 4 and the power supply device 3. At this moment, the heat generated by the transmitting device 4 and the power supply device 3 during operation is absorbed and taken away by the cooling medium in the cooling plate 51, so that the transmitting device 4 and the power supply device 3 may be cooled by the cooling plate 51 at the same time, so as to ensure that the vehicle wireless charging transmitting apparatus can work normally and the service life of the corresponding vehicle wireless charging transmitting apparatus can be ensured.

Herein, the power PCB plate 31 and the control PCB plate 32 are respectively mounted in each mounting position of the mounting groove 21 of the mounting base 2 via a fixing support 33, as shown in Fig. 8. In conjunction with Fig. 9, the external cooling apparatus outputs a low-temperature cooling medium, such as cold water, from the liquid inlet 512 of the cooling plate 51 into and flow in the cooling medium flow passage 511 so as to absorb the heat generated by the operation of the transmitting device 4 and the power supply device 3 provided on the upper and lower sides of the cooling plate 51 and turn into warm water, and then the warm water is discharged from the liquid outlet 513 of the cooling plate 51 to the external cooling apparatus, thereby achieving the circulation cooling operation for the power supply device 3 and the transmitting device 4.

Optionally, as shown in connection with Fig. 10, the cooling medium flow passages 511 are provided around the power PCB plate 31, the control PCB plate 32, and the transmitting device 4.

In the present embodiment, the cooling effect on the power PCB plate 31, the control PCB plate 32, and the transmitting device 4 is further improved by providing the cooling medium flow passages 511 around the power PCB plate 31, the control PCB plate 32, and the transmitting device 4 such that the cooling medium flow passages 511 absorb more heat generated by the operation of the power PCB plate 31, the control PCB plate 32, and the transmitting device 4 from the circumferential direction.

Optionally, the cooling plate 51 is made of a shield material.

In this embodiment, since the cooling plate 51 is made of a shield material, the cooling plate 51 not only has a liquid cooling effect on the power supply device 3 and the transmitting device 4, but also can effectively shield the interference of the electromagnetic wave generated by the operation of the transmitting device 4 on the power supply device 3, so as to ensure the normal operation of the power supply device 3.

Optionally, as shown in conjunction with Fig. 7, the vehicle wireless charging transmitting apparatus further includes an insulating plate 7 provided between the magnetic material layer 42 and the cooling plate 51.

In the present embodiment, by providing the insulating plate 7 between the magnetic material layer 42 and the cooling plate 51, when the charging box is severely crushed and deformed, a leakage problem occurs in the cooling medium in the cooling plate 51. At this moment, the insulating plate 7 can effectively prevent the cooling medium of the cooling plate 51 from being sprayed upwards into the magnetic material layer 42 or other components of the transmitting device 4, prevent a short-circuit fault of the cooling medium entering the transmitting device 4, and accordingly prolong the service life of the vehicle wireless charging transmitting apparatus.

Optionally, the vehicle wireless charging transmitting apparatus further includes two waterproof sealing structures 56, and the two waterproof sealing devices are respectively provided at the connection of the cooling plate 51 and the liquid inlet 512, and the connection of the cooling plate 51 and the liquid outlet 513.

In the present embodiment, by providing the waterproof sealing structure 56 at the connection of the cooling plate 51 and the liquid inlet 512, and at the connection of the cooling plate 51 and the liquid outlet 513, respectively, it is possible to effectively prevent the cooling medium in the cooling plate 51 from leaking out from the liquid outlet 513, or the low-temperature cooling medium provided by the external cooling apparatus from leaking out when entering the liquid inlet 512, so as to prevent the cooling medium from causing a short-circuit accident to the power supply device 3 and the transmitting device 4, thereby ensuring the normal operation of the vehicle wireless charging transmitting apparatus.

Optionally, the cooling plate 51 includes a plate body on which the cooling medium flow passage 511 is provided, and a sealing cover which is sealingly connected to the plate body.

In this embodiment, as shown in Fig. 10, the plate body has a rectangular structure with a cavity formed therein and an open top end. A cooling medium flow passage 511 is formed in the plate body, and the cooling medium can continuously flow in the cooling medium flow passage 511 and be sealingly connected to the plate body via a sealing cover, so that the cooling medium can be effectively prevented from leaking out of the plate body at the open top end. Herein, the circumferential side wall of the plate body is further provided with a turn-up which is perpendicularly connected to the plate body. When the sealing cover is mounted on the plate body, the peripheral edge of the sealing cover is connected to the turn-up of the plate body, so that the sealing performance of the sealing cover and the plate body can be correspondingly improved by increasing the contact area between the sealing cover and the plate body.

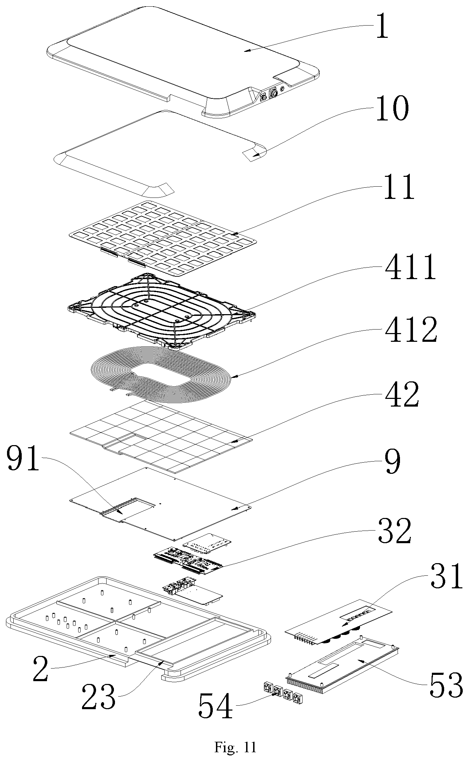

Optionally, as shown in conjunction with Figs. 11, 12, 15 and 16, the vehicle wireless charging transmitting apparatus further includes a heat dissipation assembly 5 including a heat sink 53 and a fan 54. The heat sink 53 is provided inside the charging box. At least part of the power supply device 3 is provided to the heat sink 53. The surface of the heat sink 53 is provided with a plurality of air guide channels. The fan 54 is provided to a side wall of the charging box and provided opposite to the air guide channels of the heat sink 53.

In the present embodiment, the heat sink 53 is provided inside the charging box, and the fan 54 is provided on the side wall of the charging box, thereby making full use of the inner space of the charging box. At least part of the power supply device 3 is provided on the heat sink 53, so that the heat of at least part of the power supply device 3 is transferred to the heat sink 53. A plurality of air guide channels are provided on the heat sink 53, and the fan 54 is provided opposite to the air guide channel of the heat sink 53. At this moment, by the operation of the fan 54, the air can be made to pass through the air guide channel of the heat sink 53, and the flow of air on the surface of the heat sink 53 can be accelerated so as to blow away the heat during the power supply period absorbed by the heat sink 53. When the air passes through the air guide channel in the heat sink 53, it is also possible to take away more heat absorbed by the heat sink 53 from the power supply device 3, so as to improve the cooling effect of the power supply device 3 provided on the heat sink 53, thereby achieving a better heat dissipation and cooling effect of at least part of the power supply device 3 by means of air cooling.

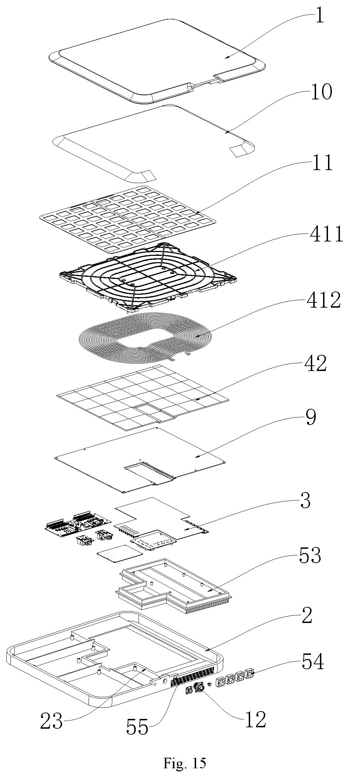

Herein, if the thickness of the mounting base 2 is greater than the thickness of the cover body 1, for example, the mounting base 2 is provided with the mounting groove 21, the heat sink 53 is mounted in the mounting base 2 of the charging box, and the fan 54 is provided on the side wall of the mounting base 2 of the charging box, as shown in Figs. 11 and 15. If the thickness of the mounting base 2 is less than the thickness of the cover body 1, for example, the bottom of the cover body 1 is provided with the mounting groove 21, the heat sink 53 is mounted in the cover body 1 of the charging box, and the fan 54 is provided on the side wall of the cover body 1 of the charging box.

In addition, the air guide channel may be provided in such a manner that, for example, a plurality of grooves provided at intervals are provided at the bottom of the heat sink 53, and each groove conducts as an air guide. Optionally, a plurality of air guide plates are provided on the lower surface of the heat sink 53, and an air guide channel is formed between two adjacent air guide plates.

Optionally, as shown in conjunction with Figs. 11, 12, and 14, the power supply device 3 includes a power PCB plate 31 and a control PCB plate 32. The coil assembly 41, the magnetic material layer 42, and the control PCB plate 32 are laminated in the direction of the central axis of the charging box. The power PCB plate 31 and the control PCB plate 32 are provided in the horizontal direction within the charging box, and the power PCB plate 31 is provided on the heat sink 53.

In the present embodiment, the coil assembly 41, the magnetic material layer 42, and the control PCB plate 32 are laminated in the direction of the central axis of the charging box, so that the size of the charging box in the horizontal direction can be effectively reduced. The power PCB plate 31 and the control PCB plate 32 are provided in a horizontal direction in the charging box, and the power PCB plate 31 is provided on the heat sink 53, so that the power PCB plate 31 with the largest heat generation can be absorbed by the heat sink 53. When driven by the fan 54, the air on the surface of the heat sink 53 is increased in flow speed, and rapid cooling of the power PCB plate 31 can be achieved, so as to ensure that the vehicle wireless charging transmitting apparatus can work for a long time, and accordingly prolong the service life thereof. The feature that the power PCB plate 31 is provided on a side of the control PCB plate 32 means that the power PCB plate 31 is provided on one side, for example, a front side, a rear side, a left side or a right side, of the control PCB plate 32 in the horizontal direction, so that the length or the width of the mounting base 2 in the charging box can be effectively reduced, so as to reduce the volume of the charging box, thereby reducing the production cost of the wireless charging apparatus.

Of course, the surface area of the heat sink 53 may be increased so that the coil assembly 41, the magnetic material layer 42, and the control PCB plate 32 are also provided on the heat sink 53, so that the coil assembly 41, the magnetic material layer 42, and the control PCB plate 32 are simultaneously cooled by the heat sink 53.

Optionally, as shown in conjunction with Figs. 11 and 15, the vehicle wireless charging transmitting apparatus further includes a second shield plate 9 provided between the magnetic material layer 42 and the power supply device 3.

In the present embodiment, when the coil assembly 41, the magnetic material layer 42, and the control PCB plate 32 are laminated along the central axis of the charging box, the coil assembly 41 and the magnetic material layer 42 generate electromagnetic interference to the power supply device 3, thereby affecting the normal operation of the power supply device 3. Thus, by providing the second shield plate 9 between the magnetic material layer 42 and the power supply device 3, the electromagnetic interference of the coil assembly 41 and the magnetic material layer 42 to the power supply device 3 can be shielded by the second shield plate 9, thereby ensuring the normal operation of the power supply device 3.

Among them, the second shield plate 9 may be an aluminum plate, and may also be a plate made of other shield materials, which is not specifically limited herein.

Optionally, as shown in conjunction with Figs. 11 and 15, the second shield plate 9 is provided with a first positioning structure 91, and the magnetic material layer 42 is provided with a second positioning structure 421 corresponding to the first positioning structure 91.

In the present embodiment, by providing a first positioning structure 91 on the second shield plate 9, the magnetic material layer 42 is provided with a second positioning structure 421, and the first positioning structure 91 corresponds to the second positioning structure 421, so that the first positioning structure 91 and the second positioning structure 421 cooperate. At the moment, by means of the first positioning structure 91 and the second positioning structure 421, not only the magnetic material layer 42 is positioned and mounted on the second shield plate 9, but also the magnetic material layer 42 and the second shield plate 9 can be prevented from relatively moving when the charging box is subjected to an external impact force. The second shield plate 9 is fixedly assembled with the magnetic material layer 42.

Here, the first positioning structure 91 may be a groove structure, and the second positioning structure 421 may be a protrusion structure, so that the magnetic material layer 42 may be positionally mounted on the second shield plate 9 in such a manner that the protrusion structure is adapted to the groove structure.

Optionally, the power supply device 3 includes a power PCB plate 31 and a control PCB plate 32. The power PCB plate 31 and the control PCB plate 32 being provided on a side of the magnetic material layer 42 away from the coil assembly 41, respectively. At least part of the power supply device 3 is provided on the heat sink 53.

In the present embodiment, as shown in conjunction with Fig. 15, the power PCB plate 31 and the control PCB plate 32 being respectively provided on a side of the magnetic material layer 42 away from the coil assembly 41 means that, with respect to the position of the magnetic material layer 42, if the coil assembly 41 is located above the magnetic material layer 42, the power PCB plate 31 and the control PCB plate 32 are both located below the magnetic material layer 42. In other words, the coil assembly 41, the magnetic material layer 42, and the power PCB plate 31 and the control PCB plate 32 in the power supply device 3 are laminated, so that it is possible to effectively reduce the length and the width in the horizontal direction in the vehicle wireless charging transmitting apparatus, to reduce the volume of the vehicle wireless charging transmitting apparatus, and thus to reduce the cost.

Since the amount of heat generated by the power PCB plate 31 is relatively large, if it cannot be cooled down, the power PCB plate 31 will be burnt, thereby affecting the normal charging operation of the whole vehicle wireless charging transmitting apparatus. Thus, in conjunction with Figs. 15 to 18, at least part of the power supply device 3, for example, the power PCB plate 31 is provided on the heat sink 53. At the moment, the heat generated by the power PCB plate 31 of the power supply device 3 during operation is transferred to the heat sink 53, so that the heat sink 53 is blown by the fan 54. Thus, the heat of the power PCB plate 31 absorbed by the heat sink 53 may be blown away to radiate and cool the power PCB plate 31, so as to ensure the normal operation of the vehicle wireless charging transmitting apparatus and prolong the service life of the corresponding vehicle wireless charging transmitting apparatus.

Furthermore, the surface area of the heat sink 53 can be made large, so that the entire power supply device 3, for example, the power PCB plate 31 and the control PCB plate 32, may both be provided on the heat sink 53, so that the entire power supply device 3 can be cooled.

Optionally, as shown in conjunction with Figs. 11, 12, 15 and 16, a third positioning structure 23 is provided in the mounting groove 21, and a fourth positioning structure is provided on the heat sink 53. The fourth positioning structure is adapted to be connected to the third positioning structure 23 when the heat sink 53 is provided in the mounting groove 21.

In the present embodiment, when the third positioning structure 23 is provided in the mounting groove 21, the third positioning structure 23 may be a mounting position surrounded by a vertical plate or a countersink 24 which is lower than the mounting groove 21. When the third positioning structure 23 is provided at the bottom of the heat sink 53, the fourth positioning structure may be a positioning frame surrounded by a vertical plate, and the fourth positioning structure is provided on the bottom wall of the heat sink 53 facing towards the mounting base 2. Therefore, when the heat sink 53 is provided in the mounting groove 21, the fourth positioning structure at the bottom of the heat sink 53 is located in and adapted to the third positioning structure 23 of the mounting base 2, thereby positioning and fixedly mounting the heat sink 53 in the mounting groove 21, so as to prevent the heat sink 53 from shaking in the mounting groove 21.

Optionally, as shown in conjunction with Fig. 15, the vehicle wireless charging transmitting apparatus further includes a connector 12 provided at a side wall of the charging box, one end of the connector 12 being electrically connected to the power supply device, and the other end of the connector being used to connect an external device.

In the present embodiment, the number of connectors 12 may be one or two or more. When the number of connectors is one, the other end of the connector is used for connecting to the mains power supply, namely, the alternating current of the mains power supply is connected to a power supply device inside the charging box via the connector 12 so as to provide an alternating current power supply for the power supply device. If the number of connectors is two or more, by way of example, the number of connectors is two, and the other end of one connector is connected to the mains supply to serve as a power supply interface. Two ends of the other connector 12 are respectively connected to a power supply device and an external display panel. The charging relevant information about the vehicle wireless charging transmitting apparatus can be displayed via the display panel. For this reaso,n the connector can serve as a communication data interface. Of course, the number of connectors may be reasonably selected according to the functions to be performed for the vehicle wireless charging transmitting apparatus, and no more examples will be given here.

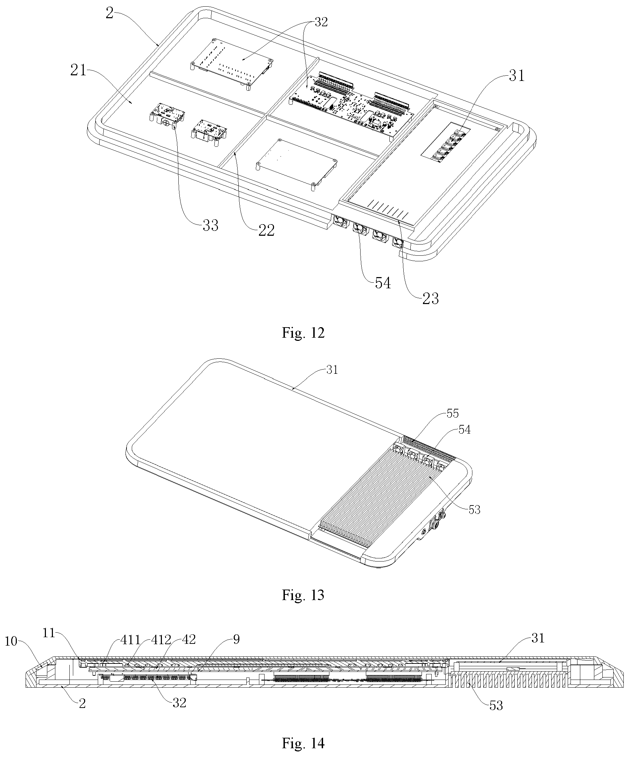

Optionally, as shown in conjunction with Figs. 11 and 12, a side wall of the mounting base 2 is provided with an avoidance opening, and the fan 54 is provided in the avoidance opening.

In the present embodiment, it is convenient to mount the fan 54 at the avoidance opening by providing the side wall of the mounting base 2 with the avoidance opening. The present embodiment makes full use of the space of the side wall of the mounting base 2 to reduce the volume of the entire charging box as compared to mounting the fan 54 outside the mounting base 2. The avoidance opening also protects the fan 54 and prevents the fan 54 from being directly exposed to the mounting base 2 and causing damage.

The number of the fans 54 may be plural, and a plurality of the fans 54 are respectively installed at the avoidance opening, so that the amount of air blown to the heat sink 53 may be increased to further improve the cooling effect of the heat sink 53.

Optionally, the heat dissipation assembly 5 further includes a protection plate 55 which is provided at the avoidance groove to shield the fan 54.

In the present embodiment, the protection plate 55 is provided at the avoidance groove so as to shield the fan 54. Herein, the surface of the protection plate 55 is provided with a plurality of heat dissipation holes. Therefore, by the protection plate 55, not only the fan 54 can be shielded to achieve safety protection for the fan 54 so as to prevent foreign objects from breaking down the fan 54, but also the heat dissipation holes can serve as an inlet for air, so that external air can be sucked into the heat sink 53 by the rotation of the fan 54, thereby performing heat dissipation and temperature reduction for the power supply device 3 on the heat sink 53. In addition, a dust screen may be installed on the surface of the protection plate 55 so as to cover the heat radiating holes, thereby further reducing the entry of dust from the outside into the interior of the fan 54, thereby reducing the maintenance cycle of the fan 54 and the heat sink 53.

Herein, the protection plate 55 is detachably mounted at the avoidance opening of the mounting base 2, so that the dust screen on the protection plate 55 and the dust on the heat dissipation hole can be cleaned by detaching the protection plate 55, and the fan 54 can also be conveniently detached and mounted.

Optionally, as shown in Figs. 6, 10, 14, and 18, the vehicle wireless charging transmitting apparatus further includes a living body detection device 10 and a foreign object detection device 11, which are provided in the charging box, respectively.

In the present embodiment, by respectively arranging the living body detection device 10 and the foreign object detection device 11 in the charging box, it is possible to respectively realize signal acquisition by the living body detection device 10 and the foreign object detection device 11. For example, the living body detection device 10 is configured for providing biological detection, such as animal and human detection, and can also be called LOD living body detection. LOD is an abbreviation of "Live Object Detect". The foreign object detection device 11 is configured for detecting whether the primary side coil 412 of the transmitting device 4 and the secondary side coil of the receiving device 13 have a metal foreign object, which can also be called metal foreign object detection. FOD is an abbreviation of "Foreign Object Detection". Here, the living body detection device 10 and the foreign object detection device 11 both adopt the prior art on the market, and are not particularly limited here.

In a second aspect, another embodiment of the present invention provides a vehicle wireless charging system including the vehicle wireless charging transmitting apparatus according to the above embodiment, and further including a receiving device 13 to which the transmitting device 4 of the vehicle wireless charging transmitting apparatus is wirelessly connected.

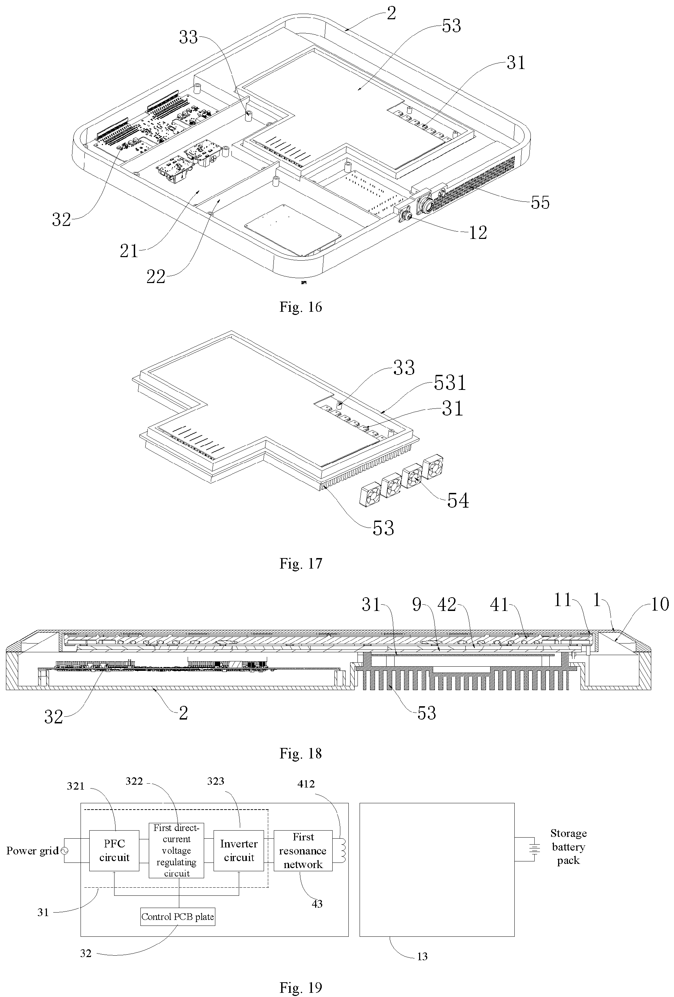

In the present embodiment, in conjunction with what is shown in Fig. 19, the power PCB plate 31 includes a PFC circuit 311, a direct-current voltage regulating circuit 312 and an inverter circuit 313. The transmitting device 4 includes a resonance network 43 and a primary side coil 412. The PFC circuit 311, the direct-current voltage regulating circuit 312, the inverter circuit 313, the resonance network 43 and the primary side coil 412 are successively connected in series. An input end of the PFC circuit 311 is connected to the mains supply. The PFC circuit 311 is a power factor correction circuit, which is not only used for improving the quality of the mains supply, such as a power supply source. Furthermore, the alternating current of the mains supply can also be converted into the direct current of one voltage grade and transmitted to the direct-current voltage regulating circuit 312. The direct-current voltage regulating circuit 312 is used for converting the direct current of one voltage grade output by the PFC circuit 311 into the direct current of another voltage grade and transmitted to the inverter circuit 313. The inverter circuit 313 is configured for converting the direct current output by the direct-current voltage regulating circuit 312 into the high-frequency alternating current and transmitting same to the resonance network 43. The resonance network 43 serves as the transmitting device 4, i. e., a resonance circuit of the emitting end, and is used for converting electric energy into high-frequency electric energy by the power supply device 3 and emitting same out through the primary side coil 412. The control PCB plate 32 is electrically connected to the PFC circuit 311, the direct-current voltage regulating circuit 312 and the inverter circuit 313, respectively, and is configured for controlling the normal operation of the PFC circuit 311, the direct-current voltage regulating circuit 312 and the inverter circuit 313.

The primary side coil 412 of the transmitting device 4 is connected to the secondary side coil of the receiving device 13 in a wireless coupling manner. The receiving device 13 is configured for converting the high-frequency electric energy received by the secondary side coil into the direct current electric energy of one voltage level, then converting the direct current electric energy of one voltage level into the direct current electric energy of another voltage level and charging a storage battery pack of the electric vehicle so as to realize a wireless charging operation on the storage battery pack of the electric vehicle.

Herein, the alternating current of the mains power supply is converted into the high-frequency electric energy by the power supply device 3 and is transmitted out by the primary side coil 412 of the transmitting device 4. The high-frequency electric energy is received by the secondary side coil of the receiving device 13 and is converted into the direct current electric energy matched with the voltage grade of the storage battery pack of the electric vehicle so as to ensure that the storage battery pack can be charged safely. Since the above-mentioned power supply device 3, the transmitting device 4 and the receiving device 13 can be implemented by using the prior art on the market, the specific circuits of the power supply device 3, the transmitting device 4 and the receiving device 13 which can achieve the above-mentioned respective functions are not particularly limited and will not be described in detail.

In addition, the power PCB plate 31, the control PCB plate 32 and the transmitting device 4 in the power supply device 3 are integrally mounted in the charging box so as to form an vehicle wireless charging transmitting apparatus, which can be provided on the ground. The receiving device 13 may be provided on the electric vehicle.

The vehicle wireless charging system has all the technical effects of the vehicle wireless charging transmitting apparatus, which will not be described in detail herein.

Although the present invention has been described above, the scope of protection of the present invention is not limited thereto. Various changes and modifications may be effected by one skilled in the art without departing from the spirit and scope of the present invention. Such changes and modifications fall within the scope of protection of the present invention.

## Claims

1. A vehicle wireless charging transmitting apparatus, **characterized by** comprising a cover body (1), a mounting base (2), a power supply device (3) and a transmitting device (4), wherein the cover body (1) is configured for covering the mounting base (2) and the two form a charging box; an accommodating space is formed between the cover body (1) and the mounting base (2); and the power supply device (3) and the transmitting device (4) are provided in the accommodating space; the transmitting device (4) comprises a coil assembly (41) and a magnetic material layer (42); the coil assembly (41), the magnetic material layer (42) and at least a part of the power supply device (3) are laminated in the direction of the central axis of the charging box; a mounting groove (21) is provided inside the mounting base (2); the power supply device (3) and the transmitting device (4) are respectively provided in the mounting groove (21); and the depth of the mounting groove (21) is greater than the thickness of the power supply device (3) and/or the transmitting device (4).

2. The vehicle wireless charging transmitting apparatus according to claim 1, **characterized in that** the charging box further comprises a first support structure (22); the first support structure (22) comprises a plurality of support ribs, and each of the support ribs is provided in the cover body (1) and/or the mounting base (2); a plurality of mounting positions are defined between the support ribs and a circumferential side wall of the cover body (1) and/or the mounting base (2); and the power supply device (3) and the transmitting device (4) are respectively provided in each of the mounting positions.

3. The vehicle wireless charging transmitting apparatus according to claim 1, **characterized by** further comprising a heat dissipation assembly (5) provided in the charging box, wherein the heat dissipation assembly (5) comprises a cooling plate (51); a cooling medium flow passage (511) is provided inside the cooling plate (51); at least part of the power supply device (3) is provided on the cooling plate (51);
the power supply device (3) comprises a power PCB plate (31) and a control PCB plate (32); the coil assembly (41), the magnetic material layer (42) and the control PCB plate (32) are laminated in the direction of the central axis of the charging box; the power PCB plate (31) and the control PCB plate (32) are arranged in a horizontal direction inside the charging box; and at least one of the power PCB plate (31), the control PCB plate (32) and the transmitting device (4) is provided on the cooling plate (51).

4. The vehicle wireless charging transmitting apparatus according to claim 3, **characterized in that** the cooling medium flow passage (511) is provided around at least one of the power PCB plate (31), the control PCB plate (32), and the transmitting device (4); and the cooling plate (51) is provided with a liquid inlet (512) and a liquid outlet (513) communicating with the cooling medium flow passage (511); the liquid inlet (512) and the liquid outlet (513) are configured for communicating with an external cooling apparatus.

5. The vehicle wireless charging transmitting apparatus according to claim 3, **characterized by** further comprising a heat dissipation assembly (5) provided in the charging box, wherein the heat dissipation assembly (5) comprises a cooling plate (51); a cooling medium flow passage (511) is provided inside the cooling plate (51); at least part of the power supply device (3) is provided on the cooling plate (51);
the power supply device (3) comprises a power PCB plate (31) and a control PCB plate (32); the power PCB plate (31) and the control PCB plate (32) are respectively provided on a side of the magnetic material layer (42) away from the coil assembly (41); and the magnetic material layer (42) and the power supply device (3) are respectively provided on two opposite sides of the cooling plate (51).

6. The vehicle wireless charging transmitting apparatus according to claim 5, **characterized in that** the cooling medium flow passage (511) is provided around the power PCB plate (31), the control PCB plate (32), and the transmitting device (4).

7. The vehicle wireless charging transmitting apparatus according to claim 5, **characterized in that** the cooling plate (51) is made of a shield material.

8. The vehicle wireless charging transmitting apparatus according to claim 5, **characterized by** further comprising an insulating plate (7) provided between the magnetic material layer (42) and the cooling plate (51).

9. The vehicle wireless charging transmitting apparatus according to any one of claims 3 to 8, **characterized in that** the cooling plate (51) comprises a plate body on which the cooling medium flow passage (511) is provided, and a sealing cover which is sealingly connected to the plate body.

10. The vehicle wireless charging transmitting apparatus according to claim 1, **characterized by** further comprising a heat dissipation assembly (5) including a heat sink (53) and a fan (54), wherein the heat sink (53) is provided in the charging box; at least part of the power supply device (3) is provided on the heat sink (53); a plurality of air guide channels are provided on a surface of the heat sink (53); and the fan (54) is provided on a side wall of the charging box and provided opposite to the air guide channels of the heat sink (53).

11. The vehicle wireless charging transmitting apparatus according to claim 10, **characterized by** further comprising a second shield plate (9) provided between the magnetic material layer (42) and the power supply device (3).

12. The vehicle wireless charging transmitting apparatus according to claim 11, **characterized in that** a first positioning structure (91) is provided on the second shield plate (9); and the magnetic material layer (42) is provided with a second positioning structure (421) corresponding to the first positioning structure (91).

13. The vehicle wireless charging transmitting apparatus according to claim 10, **characterized in that** a third positioning structure (23) is provided in the mounting groove (21); a fourth positioning structure is provided on the heat sink (53); and the fourth positioning structure is adapted to be connected to the third positioning structure (23) when the heat sink (53) is provided in the mounting groove (21).

14. The vehicle wireless charging transmitting apparatus according to any one of claims 10 to 13, **characterized in that** a side wall of the mounting base (2) is provided with an avoidance opening, and the fan (54) is provided in the avoidance opening; and the heat dissipation assembly (5) further comprises a protection plate (55) which is provided at the avoidance groove to shield the fan (54).

15. A vehicle wireless charging system, **characterized by** comprising the vehicle wireless charging transmitting apparatus according to any one of claims 1 to 14, and further comprising a receiving device (13), wherein the transmitting device (4) of the vehicle wireless charging transmitting apparatus is wirelessly connected to the receiving device (13).
